Europäisches Patentamt

European Patent Office

Office européen des brevets

(19)

(11) Veröffentlichungsnummer: **0 237 739**

**A2**

(12) **EUROPÄISCHE PATENTANMELDUNG**

(21) Anmeldenummer: 87101303.3

(22) Anmeldetag: 30.01.87

(51) Int. Cl.³: **H 01 L 23/10**
**H 01 L 25/04**

(30) Priorität: 15.02.86 DE 3604882

(43) Veröffentlichungstag der Anmeldung:
23.09.87 Patentblatt 87/39

(84) Benannte Vertragsstaaten:
CH DE FR GB IT LI NL

(71) Anmelder: BROWN, BOVERI & CIE Aktiengesellschaft
Kallstadter Strasse 1
D-6800 Mannheim 31(DE)

(72) Erfinder: Neidig, Arno, Dr. Dipl.-Phys.
Brühlerweg 42
D-6831 Plankstadt(DE)

(72) Erfinder: Bayerer, Reinhold, Dr. Dipl.-Ing.
Forststrasse 27a
D-6101 Reichelsheim(DE)

(72) Erfinder: Hahn, Bertold
Hofheim
D-6840 Lampertheim 5(DE)

(74) Vertreter: Kempe, Wolfgang, Dr. et al,
c/o BROWN, BOVERI & CIE AG ZPT Postfach 351
D-6800 Mannheim 31(DE)

(54) Leistungshalbleitermodul und Verfahren zur Herstellung des Moduls.

(57) Zur feuchtedichten Kapselung von Leistungshalbleiter-modulen (14,214,313) mit einem Kunststoffgehäuse (18) und einem aus metallisierter Keramik bestehenden Substrat (1,101,201) als Boden wird mit der Erfindung vorgeschlagen, innerhalb des Gehäuses einen Rahmen (10,110,210,310) aus Keramik oder Metall anzuordnen. Zur Herstellung des Moduls (14,214,314) wird ein Zwischenprodukt (17,117,217) gefertigt, wobei der Rahmen (10,110,210,310) dicht mit dem Substrat (1,101,201) verbunden und in einem unteren Bereich mit einer weichen Vergußmasse (15) ausgegossen wird. Das Zwischenprodukt (17,117,217) wird anschließend in ein Gehäuse (18) eingesetzt. Schließlich wird der Innenraum des Moduls (14,214,314) mit einer Hartvergußmasse (23) ausgeg-ossen.

Fig. 8

0237739

BROWN , BOVERI & CIE   AKTIENGESELLSCHAFT
Mannheim                              13. Febr. 1986
Mp.-Nr. 508/86                       ZPT/P3-Sf/Bt

Leistungshalbleitermodul und Verfahren zur Herstellung
des Moduls

Die Erfindung bezieht sich auf ein Leistungshalbleitermodul nach dem Oberbegriff des Anspruchs 1. Ein solches
Modul ist aus der DE-PS 31 27 457 bekannt. Der typische
Leistungsbereich derartiger Leistungshalbleitermodule
ist gekennzeichnet durch Ströme über 10A und Sperrspannungen von etwa 400V bis 2000V, entsprechend Netzanschlußanspannungen bis 600V$_{eff}$. Module in diesem Leistungsbereich können in Löttechnik oder in Druckkontakttechnik hergestellt werden. Die vorliegende Erfindung
bezieht sich auf Module in Löttechnik und dabei insbesondere auf das Problem der feuchtedichten Kapselung.
Außerdem bezieht sich die Erfindung auf Verfahren zur
Herstellung von Modulen mit feuchtedichter Kapselung.

Bei bekannten Modul-Konstruktionen schaden Feuchtigkeiten bis zu 70% relativer Luftfeuchte meistens nicht. Für
manche Anwendungen werden jedoch höhere Anforderungen an
die Feuchtedichtigkeit gestellt. Übliche Testbedingungen
sind in solchen Fällen z.B. eine 100-stündige Lagerung der Bauelemente in einer Autoklave bei 0,2MPa Wasserdampfdruck und einer Temperatur von 120°C oder eine
1000-stündige Lagerung bei 85°C und 85% relativer Luftfeuchte. Während der Lagerung können die Bauelemente
auch mit einer elektrischen Spannung beaufschlagt sein.
Außerdem können der Atmosphäre korrosive Agenzien zugemischt sein (z.B. Salzsprühnebeltest, $SO_2$-Beimischun-
gen).

Feuchtigkeit kann die Sperrfähigkeit der in die Module
eingebauten Halbleiterchips beeinträchtigen. Ferner kann
die Isolationsfestigkeit verloren gehen. Bei abschaltbaren Thyristoren können die feingliedrigen Metallisierungsbahnen auf den Chips korrodieren, wodurch es zu
Stromunterbrechungen oder Kurzschlüssen zwischen Steuer-
und Leistungselektroden kommen kann.

Bisher ist keine wirklich feuchtedichte Modulkonstruktion mit Kunststoffgehäuse bekanntgeworden, obwohl es
nicht an Bemühungen gefehlt hat, Module feuchtedicht
auszuführen. Undichtigkeiten entstehen bei üblichen Modulen mit einem Kunststoffgehäuse und als Bodenplatte
eingesetzten Keramiksubstrat dadurch, daß die relativ
dünnen Kunststoffgehäusewände und die Nahtstellen zwischen Gehäuse und Bodenplatte z.B. wegen nicht einwandfreier Klebung Wasserdampf hindurchlassen. Die Klebestelle kann auch nach häufigen Temperaturwechseln aufreißen. Bei einem solchen Modul ist zwar sowohl das Gehäuse als auch das Substrat dünn ausgeführt, wodurch
sich die Teile bei Temperaturänderung durch Verbiegen
der Teile aneinander anpassen können, trotzdem sind solche Module nicht dauerhaft feuchtedicht.

Es liegt nahe, zur Vermeidung von Problemen, die durch
das Kunststoffgehäuse verursacht sind, Keramik anstelle
von Kunststoff zu verwenden. Ein solches keramisches Gehäuse wird z.B. in dem EP-Patent 0 037 301 vorgeschlagen. Dabei ist ein haubenförmiges Gehäuse vorgesehen, das auf einem Keramiksubstrat befestigt ist und das auf seiner Oberseite Löcher aufweist, durch die Metallstifte für Außenanschlüsse geführt sind. Aus verschiedenen Gründen ist dieses Konzept jedoch nicht für Module höherer Leistung geeignet. Bei Stromstärken ab etwa 100A müssen Kupferstifte mit mindestens 10mm$^2$ Querschnitt verwendet werden. Dabei kann es wegen unterschiedlicher Ausdehnung von Kupfer und Keramik zu Rissen in der Keramik kommen. Außerdem sind Probleme durch die vorgeschlagene Montage des Moduls mittels Schrauben durch Bohrungen im Keramiksubstrat auf einen Kühlkörper zu erwarten. Auch wenn elastische Beilagscheiben verwendet werden, ist die Gefahr eines Bruchs der Keramik sehr groß, wenn z.B. M5-Schrauben verwendet werden, die mit Drehmomenten zwischen 2 und 3Nm festgezogen werden. Stabilere, d.h. dickere Keramiksubstrate können mit Rücksicht auf den Wärmewiderstand nicht verwendet werden. Eine Schraubbefestigung mit Hilfe von Schrauben in dem im Vergleich zum Substrat dickeren Gehäuse ist wegen der außerordentlichen Sprödigkeit der keramischen Werkstoffe nicht geeignet. Um die notwendige elektrische Überschlagsfestigkeit zu erreichen, müßte das Modul mit Vergußmasse ausgefüllt werden. Hierzu fehlt in der genannten Patentschrift ein Hinweis, insbesondere fehlt die Angabe einer Einfüllöffnung und eine Anweisung, wie eine solche Öffnung abzudichten wäre.

Aus der DE-OS 33 18 289 ist ebenfalls ein Vorschlag zu einem feuchtedichten Modul zu entnehmen, wobei auch hier ein Keramikgehäuse vorgesehen ist. Das Modulgehäuse wird dabei durch mehrere Teile gebildet, die mit Glas beschichtet sind. Zum Schließen des Gehäuses müssen diese Glasschichten geschmolzen werden. Da dieser Schmelzvorgang nach dem Lötvorgang erfolgt und eine höhere Temperatur als der Lötvorgang erfordert und auch eingefülltes Silikonharz keine hohe Temperatur verträgt, dürfen nur die Verbindungsstellen die erforderliche hohe
Temperatur annehmen. Deshalb wird ein Verfahren mit einem Mikrobrenner oder einem Laserstrahl vorgeschlagen,
wodurch hohe Kosten entstehen. Im Hinblick auf den Wärmewiderstand ist auch die vorgesehene dicke Metallbodenplatte mit W- oder Mo-Ausgleichsscheibe nachteilig.

Weitere feuchtedichte Anordnungen sind auch aus der Informationselektronik bekannt, deren Konzept jedoch nicht
auf Module der Leistungselektronik übertragbar ist, weil
z.B. Metallgehäuse verwendet werden, wobei sich zu kurze
Kriech- und Luftstrecken ergeben.

Der vorliegenden Erfindung liegt die Aufgabe zugrunde,
eine feuchtedichtes Leistungshalbleitermodul mit einem
Kunststoffgehäuse anzugeben, das den obengenannten Testbedingungen entspricht. Außerdem sollen Herstellverfahren für ein solches Modul angegeben werden.

Diese Aufgabe wird bei einem Leistungshalbleitermodul
nach dem Oberbegriff des Anspruchs 1 durch dessen kennzeichnende Merkmale gelöst. Vorteilhafte Ausgestaltungen
sowie Herstellverfahren sind in den weiteren Ansprüchen
angegeben.

Die damit vorgeschlagene Lösung ist nicht auf einen bestimmten Leistungsbereich begrenzt und hat außerdem den
Vorteil, daß das Modul auch in Transformatorenöl eingesetzt werden kann. Bei bekannten Modulkonstruktionen
besteht dagegen die Gefahr, daß Öl über die Klebestelle
ins Innere eindringt, die Silikonvergußmasse zum Quellen
bringt, die dann das Gehäuse sprengt.

Der erfindungsgemäße Rahmen zur Feuchtigkeitsdichtung kann aus einer dichten Keramik oder aus Metall hergestellt werden. Im Falle eines Keramikrahmens soll die Keramik die gleichen thermischen Ausdehnungseigenschaften aufweisen, wie das mit Kupfer beidseitig dick beschichtete Substrat. Eim Metallrahmen soll entweder die gleichen Ausdehnungseigenschaften wie das Substrat haben, oder so nachgiebig sein, wie z.B. 0,3mm dickes duktiles Kupferblech, damit keine unzulässig hohen mechanischen Spannungen auf das Substrat ausgeübt werden.

Es muß in jedem Fall eine dichte Verbindung zwischen dem Rahmen und dem Substrat hergestellt werden. Dies kann z.B. durch Weichlöten, durch Kleben oder durch Anwendung eines Direct-Bonding-Verfahrens erreicht werden.

Zur Herstellung einer dichten Verbindung durch Weichlöten wird der Fuß eines Keramikrahmens und der Rand des Substrats in geeigneter Weise metallisiert. Diese Metallisierung kann z.B. in Dickschichttechnik ausgeführt werden, wobei zur Verbesserung der Lötfähigkeit eine Verstärkung durch chemisch abgeschiedene Nickel- und Gold-Schichten vorgesehen werden kann.

Die Herstellung der Verbindung zwischen Rahmen und Substrat durch ein Direct-Bonding-Verfahren bietet sich besonders bei Verwendung eines Kupferrahmens an. Aber auch Keramikrahmen können auf diese Weise mit dem Substrat verbunden werden, wobei der Keramikrahmen in diesem Fall zweckmäßig so gestaltet wird, daß er beim anschließenden Einlöten von Bauteilen als verlorene Lötform dienen kann. Da bei dieser Herstellungsweise ein späteres Drahtbonden mittels Ultraschall zur Herstellung von Drahtverbindungen zwischen Halbleiterchips und Leiterbahnen schwierig ist, bietet sich dieses Verfahren besonders für Thyristor und Diodenmodule an, bei denen kein Drahtbonden erforderlich ist.

Wenn Drahtbonden erforderlich ist, wählt man zweckmäßig ein Herstellverfahren, bei dem ein Rahmen nach dem Bestücken einschließlich Löten und Drahtbonden in einem zweiten Lötschritt mit niedriger schmelzendem Weichlot mit dem Substrat verbunden wird.

Wenn die Rahmen-Substrat-Verbindung durch Kleben hergestellt wird, ist auf eine ausreichend breite Klebeverbindung zu achten, damit eine Eindiffusion von Wasserdampf in das Modul während Feuchtigkeits-Tests vermieden wird. Die erforderliche Breite des zur Klebung vorgesehenen Randes hängt von der jeweiligen Beanspruchung ab. Vorzugsweise ist als Klebemittel ein Duroplast wie z.B. Epoxidharz vorzusehen, da Epoxidharze im Gegensatz zu Silikonelastomeren, eine geringere Durchlässigkeit für Wasserdampf aufweisen. Bei der üblichen Aushärtetemperatur des Epoxidharzes von 130°C treten noch keine Biegespannungen an dem Substrat, d.h. an der metallisierten Keramik auf. Dadurch kann ein schmaler Klebespalt zwischen Rahmen und Substrat erzielt werden, der dem Wasserdampf wenig Angriffsfläche bietet. Epoxidharze haften außerdem gut auf Keramik und Metall.

Ein Rahmen aus Keramik sollte im oberen Bereich verstärkt ausgeführt werden, um den Kräften beim Aushärten und Schrumpfen der Hartvergußmasse standzuhalten. Falls eine solche Verstärkung nicht möglich ist, z.B. bei einer Ausführung des Rahmens zur Verwendung als verlorene Lötförm, kann auch vor dem Hartvergießen ein Körper aus billigem, aber dichtem keramischen Material eingesetzt werden. Die erforderliche Dicke der Hartvergußschicht richtet sich nach der Feuchtebeanspruchung. Durch Verrippung des Rahmens bzw. durch einen Einsatzkörper werden Risse in der Keramik oder im Epoxidharz nach dem Aushärten wirksam vermieden. Die Verrippung oder Einsatzkörper sind so zu gestalten, daß sie elektrische Anschlüsse nicht behindern. Durch die Anwendung der Vergießtechnik ist gewährleistet, daß auch dicke Kupferanschlüsse mit größeren Toleranzen bezüglich der Abmessungen und ihrer Position auf dem Substrat aus dem Gehäuse feuchtedicht herausgeführt werden können. Durch die gute thermische Anpassung von Substrat und Rahmen besteht auch nicht die Gefahr, daß die Lötung oder Klebung zwischen Rahmen und Substrat einreißt und undicht wird.

Es zeigen:

Fig. 1       Draufsicht auf die Oberseite einer Keramikplatte mit strukturierter Metallisierung,

Fig. 2       Seitenansicht der in Fig. 1 dargestellten beideitig metallisierten Keramikplatte,

Fig. 3       Draufsicht auf das bestückte und verlötete Substrat (metallisierte Keramikplatte),

Fig. 4       Draufsicht auf einen Keramikrahmen,

Fig. 5       Schnitt durch den Keramikrahmen in einer Ebene A-A,

Fig. 6       Schnitt durch den Keramikrahmen in einer Ebene B-B,

Fig. 7       mit dem Substrat verlöteter Keramikrahmen,

Fig. 8       Schnitt durch einen Leistungshalbleitermodul mit Keramikrahmen zur Feuchtigkeitsdichtung,

Fig. 9       räumliche Darstellung des Leistungshalbleitermoduls gemäß Fig. 8,

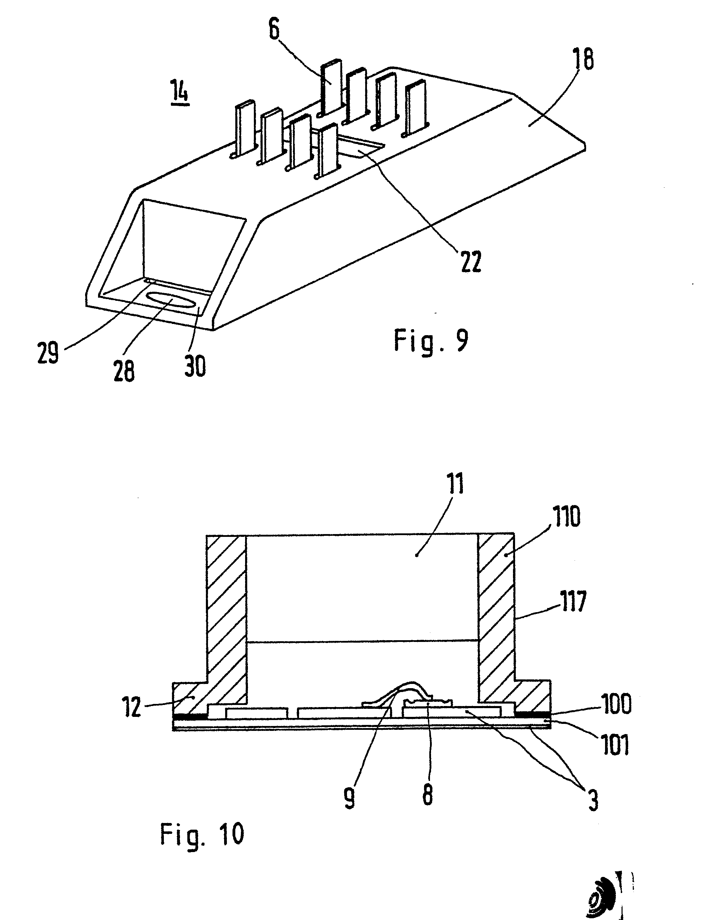

. Fig. 10          Ausführungsvariante mit einem Substrat, das durch Kleben mit dem Keramikrahmen verbunden ist,

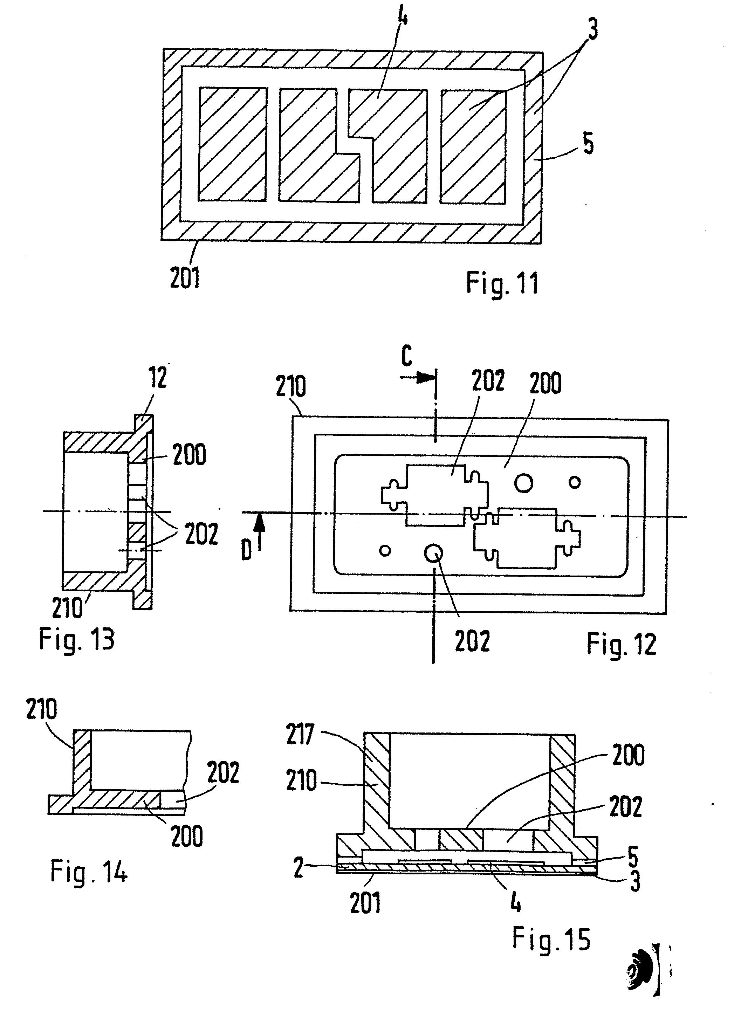

Fig. 11           Draufsicht auf ein Substrat für ein
                  Ausführungsbeispiel mit einem Keramikrahmen, der einen Zwischenboden
                  mit Aussparungen als verlorene Lötform enthält,

Fig. 12 bis 14    Darstellung des Keramikrahmens mit
                  Zwischenboden,

Fig. 15           Darstellung des Rahmens gemäß
                  Fig. 12 nach der Verbindung mit dem
                  Substrat,

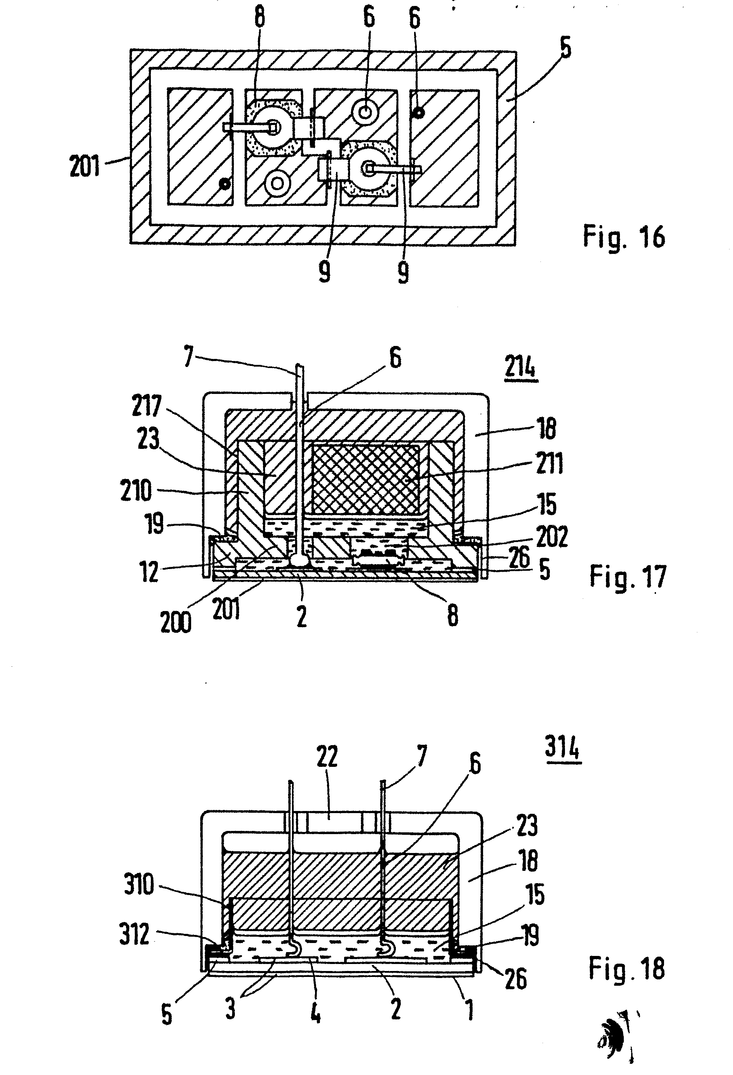

Fig. 16           bestücktes Substrat für das Modul
                  gemäß Fig. 17,

Fig. 17           fertiggestelltes Modul mit dem Rahmen gemäß Fig. 12 und 15,

Fig. 18           Modul mit einem Metallrahmen zur
                  Dichtung gegen Feuchtigkeit.

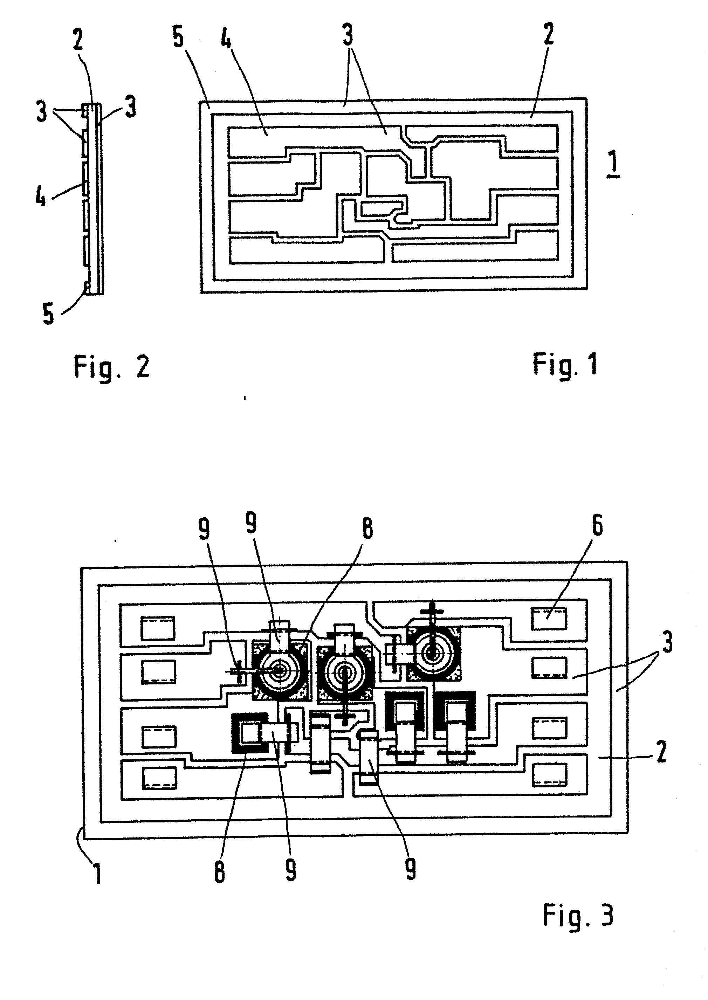

Fig. 1 zeigt ein erstes Substrat 1, das aus einer Keramikplatte 2 aus Aluminiumoxid (Reinheit mindestens 96%)
besteht, die auf der Oberseite und Unterseite eine mindestens 0,1mm dicke, bevorzugt 0,3mm dicke Metallisierung 3 trägt. Die Metallisierung 3 ist durch direktes
Verbinden von Kupferfolien mit der Keramikplatte 2 nach
einem sogenannten Direct-Bonding-Verfahren hergestellt.
Auf der Oberseite, die später dem Modul-Inneren zugewandt ist, ist die Metallisierung 3 strukturiert. Die
Struktur kann z.B. durch Ätzen der bereits mit der Keramik 2 verbundenen Kupferfolie hergestellt werden oder
durch entsprechendes Stanzen der Kupferfolie vor der
Verbindung mit der Keramikplatte 2. Mit der Strukturierung werden übliche Leiterbahnen 4 auf dem Substrat 1
hergestellt und außerdem ein etwa 2 bis 3mm breiter umlaufender Metallrand 5. Der Abstand des Metallrandes 5 von den Leiterbahnen 4 ist so bemessen, daß eine Isolationsfestigkeit von 2,5kV (1min) Effektivwert in vergossenem Zustand erreicht wird. Die angegebene Breite des Metallrandes 5 von etwa 2 bis 3mm ist erforderlich um eine dichte lunkerfreie Lötverbindung zu erreichen.

Fig. 2 zeigt eine Seitenansicht des in Fig. 1 in Draufsicht dargestellten Substrats 1.

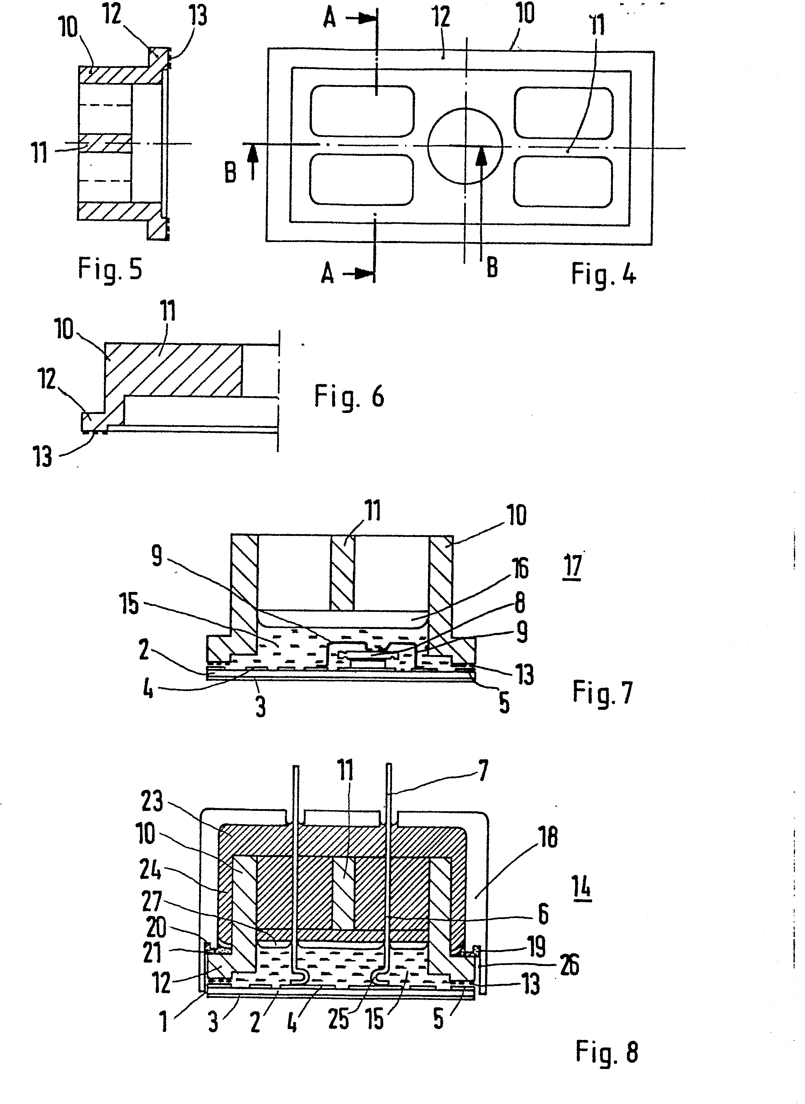

Fig. 3 zeigt das Substrat 1 nach einem weiteren Herstellungsschritt. Dabei wurde das Substrat 1 mit Anschlußelementen 6 für äußere Anschlüsse 7 (siehe Fig. 8), Halbleiterbauelementen 8 und Verbindungselementen 9 bestückt und mit einem Lot verlötet, dessen Schmelztemperatur T1 bei etwa 300°C liegt (z.B. Pb5Sn).

Fig. 4 zeigt einen ersten Keramikrahmen 10 in Draufsicht. Der aus Keramik, z.B. Steatit oder Stealan, wie es von der Fa. Sembach in D-8560 Lauf angeboten wird, bestehende Rahmen 10 weist eine Verrippung 11 sowie an seinem Fuß einen Absatz 12 auf. Der Keramikrahmen 10 ist zum Einsatz in ein Leistungshalbleitermodul 14 (siehe Fig. 8) vorgesehen.

Fig. 5 zeigt den Keramikrahmen 10 bei einem Schnitt durch die in Fig. 4 eingetragene Schnittebene A-A. Die Unterseite des Absatzes 12 des Rahmens 10 ist umlaufend mit einer Metallschicht 13 versehen, die zweckmäßig mit einem Lot vorbenetzt wird.

Fig. 6 zeigt den Rahmen 10 bei einem Schnitt durch die in Fig. 4 eingetragene Schnittebene B-B.

Fig. 7 zeigt als Schnittbild ein Zwischenprodukt 17, das aus dem Rahmen 10 und dem damit verlöteten, bestückten Substrat 1 besteht. Zur Lötung kann als Lot z.B. PbSn verwendet werden. Die Löttemperatur T2 muß unterhalb der Schmelztemperatur T1 des beim vorherigen Lötvorgangs benutzten Lots liegen, also z.B. bei 180°C bis 230°C.

Wie aus Fig. 7 zu entnehmen ist, wird der metallisierte und vorbelotete Absatz 12 des Keramikrahmens 10 mit dem Metallrand 5 auf der Keramikplatte 2 verlötet. Durch die Vorbelotung der Metallschicht 13 auf der Unterseite des Absatzes 12 kann auf ein aufwendiges Einlegen einer Lotfolie vor dem Lötvorgang verzichtet werden. Nach dem Lötvorgang wird die Substratoberfläche durch Eingießen einer weichen elastomeren Vergußmasse 15 in den Rahmen 10 abgedeckt. Dabei wird der Raum über dem Substrat 1 bis zu einer Höhe von ca. 3mm unterhalb der Verrippung 11 mit der Vergußmasse 15 gefüllt. Es kann zweckmäßig sein, die elastomere Vergußmasse 15 mit mineralischen Füllstoffen wie Quarz- oder Dolomit-Mehl zu füllen, um die große thermische Volumendehnung des Elastomers zu verringern. Die Verrippung 11 ist so ausgeführt, daß zwischen der Verrippung 11 und dem Substrat 1 ein Raum 16 für Halbleiterelemente 4 und Verbindungselemente 9 übrig bleibt.

Fig. 8 zeigt einen Schnitt durch ein fertiges Leistungshalbleitermodul 14. Das Modul 14 entsteht dadurch, daß das in Fig. 7 dargestellte Zwischenprodukt 17 in ein Kunststoffgehäuse 18 eingebaut wird. Das Kunststoffgehäuse 18 weist unten eine Öffnung auf, in die das Zwischenprodukt 17 eingesetzt und mit Hilfe einer elastomeren Silikondichtungsmasse 19 verbunden wird. Eine Auflagefläche 21 ist mit einer Nut 20 zur Aufnahme von Dichtungsmasse 19 versehen. Die Tiefe einer Ausnehmung 26 zur Bildung der Auflagefläche 21 ist so gewählt, daß das Substrat 1 geringfügig über den Rand des Bodens des Kunststoffgehäuses 18 hinausragt. Dadurch wird bei späterer Montage des Leistungshalbleitermoduls 14 auf einen nicht dargestellten Kühlkörper ein ausreichender

Anpreßdruck erreicht. Durch eine Einfüllöffnung 22 (siehe Fig. 9) an der Oberseite des Kunststoffgehäuses 18 wird Epoxidharz als Vergußmasse 23 eingefüllt und somit der Innenraum des Leistungshalbleitermoduls 14 vollständig ausgefüllt. Dadurch wird nicht nur eine gute mechanische Verbindung zwischen dem Zwischenprodukt 17 und dem Kunststoffgehäuse 18 erreicht, sondern auch die angestrebte Dichtung gegen Feuchtigkeit. Die Hartvergußmasse 23 füllt einen etwa 1 bis 2mm breiten Zwischenraum 24 zwischen den Rahmen 10 und den Seitenwänden des Kunststoffgehäuses 18 sowie den übrigen Innenbereich des Moduls 14 aus. Es ist üblich und zweckmäßig, die Hartvergußmasse 23 mit Mineralmehl zu füllen.

Bei der Darstellung in Fig. 8 ist das Substrat 1 in einer anderen Stelle geschnitten als in Fig. 7. Deshalb sind in Fig. 8 anstelle der Halbleiterbauelemente 8 und Verbindungselemente 9 die Anschlußelemente 6 sichtbar, die an ihrem Fußende einen Dehnungsbogen 25 aufweisen. Der Dehnungsbogen 25 entlastet die Weichlötverbindung am Substrat 1.

Da die Hartvergußmasse 23 sowohl mit der äußeren Wand des Rahmens 10 als auch über dessen oberen Rand hinweg mit der hinteren Wand des Rahmens 10 Kontakt hat, wird ein Ablösen der Hartvergußmasse 23 wesentlich erschwert und somit eine gute Haftung und gute Dichtung erzielt. Damit die Hartvergußmasse 23 in der beschriebenen Weise um den oberen Rand des Rahmens 10 greifen kann, sollte das Gehäuse 18 so ausgeführt werden, daß zwischen dem Gehäusedeckel und dem oberen Rand des Rahmens 10 etwa ein Abstand von 5mm besteht. Durch einen langen Kontaktbereich zwischen den Anschlußelementen 6 und der Hartvergußmasse 23 wird auch an dieser kritischen Stelle ein Eindringen von Feuchtigkeit vermieden. Nach dem Aushärten der Hartver, gußmasse 23 entsteht zwischen der Hartvergußmasse 23 und der weichen Vergußmasse 15 ein Abstand 27, der jedoch keinen Einfluß auf die Dichtwirkung hat. Dieser Abstand 27 entsteht durch die hohe Volumenausdehnung des Elastomers 15 nach dem Aushärten der Hartvergußmasse 23 bei einer Temperatur von z.B. 140°C und dem anschließenden Abkühlen. Der Abstand 27 gewährleistet, daß sich die Weichvergußmasse 15 beim späteren Betrieb des Bauelementes frei ausdehnen kann.

Fig. 9 zeigt eine räumliche Darstellung des Moduls 14. Dabei ist im Gehäusedeckel die Einfüllöffnung 22 für die Vergußmasse 23 zu erkennen. Das Kunststoffgehäuse 18 weist in üblicher Weise Befestigungslaschen 30 mit einem Befestigungsloch 28 auf. Außerdem ist im Übergangsbereich zwischen dem Flansch 30 und der Gehäusewand jeweils ein Schlitz 29 vorgesehen, wodurch die Übertragung von mechanischen Spannungen durch die Schraubenbefestigung auf das Substrat verhindert wird.

Alternativ zu der anhand der Figuren 1 bis 7 beschriebenen Herstellung des Zwischenprodukts 17, also des mit dem Rahmen 10 verbundenen Substrats 1 kann auch ein zweites Zwischenprodukt 117 hergestellt werden, das in Fig. 10 dargestellt ist. Dabei geht man von einem zweiten Substrat 101 aus, das sich von dem in Fig. 3 dargestellten ersten Substrat 1 dadurch unterscheidet, daß kein Metallrand vorgesehen ist. Außerdem wird ein zweiter Keramikrahmen 110 verwendet, der auf der Unterseite seines Absatzes 12 keine Metallschicht aufweist. Die Verbindung des zweiten Rahmens 110 mit dem zweiten Substrat 101 erfolgt durch Kleben. Dabei kann als Klebstoff 100 zweckmäßig ein Einkomponenten-Epoxidharz benutzt werden. Nach dem Aushärten des Klebstoffs 100 wird in gleicher Weise wie zuvor beschrieben, das Modul 14 fertiggestellt.

Ein weiteres Ausführungsbeispiel, wobei ebenfalls ein Leistungshalbleitermodul mit einem Dichtungsrahmen aus Keramik hergestellt wird, ist in den Figuren 11 bis 17 dargestellt.

Fig. 11 zeigt ein drittes Substrat 201, das wie das in Fig. 1 dargestellte erste Substrat 1 einen Metallrand 5 und Leiterbahnen 4 aufweist. Die Leiterbahnen 4 haben in diesem Beispiel lediglich eine andere Flächengestaltung.

Fig. 12 zeigt einen dritten Keramikrahmen 210 in Draufsicht. Dieser Rahmen 210 weist in seinem oberen Bereich keine Verrippung auf, jedoch in seinem unteren Bereich einen Zwischenboden 200 mit Aussparungen 202. Fig. 13 zeigt einen Schnitt durch die in Fig. 12 eingetragene Ebene C und Fig. 14 einen Schnitt durch die Ebene D.

Fig. 15 zeigt den dritten Keramikrahmen 210 in einem Schnittbild, nachdem er mit dem dritten Substrat 201 zu einem dritten Zwischenprodukt 217 verbunden wurde. Diese Verbindung kann vorteilhaft nach einem Direct-Bonding-Verfahren erfolgen, wobei zweckmäßig gleichzeitig die Metallisierung 3 auf der Unterseite des Substrats 201 hergestellt wird. Bei diesem Verbindungsvorgang befindet sich die in Fig. 15 dargestellte Anordnung auf den Kopf gestellt, also mit dem Rahmen 210 unten liegend, in einem Ofen.

Nachdem der Rahmen 210 mit dem Substrat 201 verbunden ist, werden Bestückungselemente, nämlich Halbleiterbauelemente 8, Verbindungselemente 9 und Anschlußelemente 6 eingesetzt und verlötet. Dabei wird der Zwischenboden 200 mit seinen Aussparungen 202 als sogenannte verlorene Lötform benutzt. Das bestückte Substrat 201, ohne Darstellung des darüber befindlichen Rahmens 210, ist in Fig. 16 in Draufsicht gezeigt. Im dargestellten Beispiel wurden als Verbindungselemente 9 Verbindungslaschen mit Seitenflügeln gemäß DE-OS 31 27 458 eingesetzt.

Fig. 17 zeigt ein fertig gestelltes zweites Modul 214, das das in Fig. 15 dargestellte dritte Zwischenprodukt 217 enthält. Zur Herstellung dieses Moduls 214 wird in das Zwischenprodukt 217 nach der beschriebenen Bestükkung und Verlötung mit Bestückungselementen 6, 8, 9 zunächst die weiche Vergußmasse 15 eingefüllt. Nachdem diese vernetzt ist, wird ein Keramikeinsatz 211 in den Rahmen 210 als Ersatz für die fehlende Verrippung eingesetzt. Anschließend wird das so bestückte Zwischenprodukt 217 in ein Kunststoffgehäuse 18 eingesetzt und mit Hilfe von Dichtungsmasse 19 verbunden. Schließlich wird das Modul 214 mit Hartvergußmasse 23 ausgefüllt.

Ein letztes Ausführungsbeispiel ist in der Fig. 18 dargestellt. Fig. 18 zeigt ein drittes Modul 314, das sich von den zuvor beschriebenen Beispielen dadurch unterscheidet, daß anstelle eines Keramikrahmens ein Metallrahmen 310 eingesetzt ist. Der Rahmen 310 kann z.B. aus dünnem Kupferblech oder Nickeleisenblech als Stanzteil oder Tiefziehteil hergestellt sein. Der dargestellte Rahmen 310 ist etwa 10mm hoch und die untere Kante ist nach außen gebogen zu einem etwa 4mm breiten Fuß 312. Der Rahmen 310 enthält keine Verrippung. Die Verbindung des Rahmens 310 mit dem Substrat 1 kann durch Löten oder durch direktes Verbinden (direct-bonding) erfolgen. Bei Verwendung von Nickeleisenblech ist das bekannte Problem der unterschiedlichen Ausdehnung von Rahmen 310 und Substrat 1 vermieden, da die Ausdehnungskoeffizienten von Nickeleisenblech und Keramik ähnlich sind. Um die Haftung zwischen Metallrahmen 310 und der Hartvergußmasse 23 zu verbessern, kann die Blechoberfläche z.B. durch Sandstrahlen aufgerauht werden.

Es ist wesentlich, die Blechstärke für den Rahmen 310 so dünn zu wählen, z.B. 0,3mm dick, daß keine unzulässig hohen mechanischen Spannungen auf das Substrat 1 ausgeübt werden und daß die Vergußmasse 23 beim Schrumpfen das Blech leicht nach innen ziehen kann, ohne das Substrat 1 unzulässig zu verbiegen. Außerdem müssen die Abstände zwischen dem Rahmen 310 und den Leiterbahnen 4 und den Bestückungselementen 6, 8, 9 so groß sein, daß die geforderte Isolationsfestigkeit gegeben ist. Da der Rahmen 310 umgossen wird, lassen sich die erforderlichen Kriech- und Luftstrecken problemlos erreichen. Der übrige Aufbau des Moduls 314 entspricht dem ersten Ausführungsbeispiel.

Selbstverständlich sind je nach Anforderungen an das Modul weitere Ausführungsvarianten möglich, bei denen ebenfalls von der Erfindung Gebrauch gemacht wird. So kann z.B. anstelle eines Kunststoffgehäuses 18 lediglich ein Bügel aus Kunststoff oder aus Metall zur Befestigung des beschriebenen Zwischenproduktes 17, 117, 217 mit Keramikrahmen 10, 110, 210 auf einem Kühlkörper vorgesehen werden. In diesem Fall wird lediglich der Innenraum des Keramikrahmens 10, 110, 210 bis knapp unter die Oberkante mit Hartvergußmasse 23 ausgefüllt.

BROWN, BOVERI & CIE    AKTIENGESELLSCHAFT
Mannheim                                6. Okt. 1986
Mp.-Nr. 508/86                          ZPT/P3-Sf/Bt

A n s p r ü c h e

1. Leistungshalbleitermodul mit einem Kunststoffgehäuse, in das als Gehäuseboden ein Substrat eingesetzt ist, das aus einer Keramikplatte besteht, die auf der oberen und unteren Seite mit einer Metallisierung versehen ist, wobei die Metallisierung auf der oberen, dem Gehäuseinneren zugewandten Seite der Keramikplatte strukturiert ist zur Bildung von Leiterbahnen und wobei die obere Seite bestückt ist mit Leistungshalbleiterbauelementen, Verbindungselementen und Anschlußelementen für äußere Anschlüsse, dadurch gekennzeichnet, daß innerhalb des Gehäuses (18) ein Rahmen (10,110,210,310) zur Abdichtung gegen Feuchtigkeit vorgesehen ist, der mit dem Substrat (1,101,201) verbunden ist.

2. Leistungshalbleitermodul nach Anspruch 1, dadurch gekennzeichnet, daß die Metallisierung auf der Keramikplatte mindestens 0,1mm, bevorzugt 0,3mm dick ist.

3. Leistungshalbleitermodul nach Anspruch 1 oder 2, dadurch gekennzeichnet, daß der Rahmen (10,110,210) aus einer Keramik mit etwa gleichen thermischen Ausdehnungseigenschaften wie das Substrat (1,101,201) besteht.

4. Leistungshalbleitermodul nach Anspruch 1 oder 2, dadurch gekennzeichnet, daß der Rahmen (310) aus Metall besteht.

5. Leistungshalbleitermodul nach Anspruch 4, dadurch gekennzeichnet, daß der Rahmen (310) aus duktilem Kupferblech besteht.

6. Leistungshalbleitermodul nach Anspruch 4, dadurch gekennzeichnet, daß der Rahmen (310) aus Nickeleisenblech besteht.

7. Leistungshalbleitermodul nach Anspruch 1 bis 3, dadurch gekennzeichnet, daß der Rahmen (10,110) eine Verrippung (11) aufweist.

8. Leistungshalbleitermodul nach Anspruch 1 bis 7, dadurch gekennzeichnet, daß mit der Metallisierung (3) auf der Oberseite der Keramikplatte (2) außer den Leiterbahnen (4) ein Metallrand (5) gebildet ist.

9. Leistungshalbleitermodul nach Anspruch 1 bis 3, dadurch gekennzeichnet, daß der Rahmen (210) einen Zwischenboden (200) aufweist, der als Lötform vorgesehen ist.

10. Verfahren zur Herstellung eines Leistungshalbleitermoduls nach Anspruch 1, gekennzeichnet durch nachstehende Verfahrensschritte:

a) Herstellen des Substrats (1) durch Aufbringen der Metallisierung (3) auf die Ober- und Unterseite der Keramikplatte (2) und Strukturierung der oberen Metallisierung (3) zu Leiterbahnen (4) und einen Metallrand (5),

b) Bestücken und Verlöten des Substrats (1) mit Bestückungselementen (6,8,9),

c) Bereitstellen des Rahmens (10) aus Keramik, wobei der Rahmen (10) in seinem oberen Bereich eine Verrippung (11) und an seinem Fuß einen Absatz (12) aufweist,

d) Verbinden des Rahmens (10) mit dem Substrat (1) zur Herstellung eines Zwischenprodukts (17), wobei die Unterseite des Absatzes (12) mit dem Metallrand (5) verbunden wird und Vergießen eines unteren Bereiches im Zwischenprodukt (17) bis einige Millimeter unterhalb der Verrippung (11) mit einer weichen Vergußmasse (15),

e) Einsetzen des Zwischenprodukts (17) in das Kunststoffgehäuse (18), das an seiner Oberseite Öffnungen zur Durchführung der Anschlußelemente (6) für äußere Anschlüsse (7) sowie zum Einfüllen einer Hartvergußmasse (23) aufweist, wobei das Kunststoffgehäuse (18), das an seinem unteren Rand eine Ausnehmung (26) aufweist, im Bereich der Ausnehmung (26) und des Absatzes (12) am Rahmen (10) mit einer Dichtungsmasse (19) abgedichtet wird und

f) Vergießen des verbleibenden oberen Bereiches innerhalb des Gehäuses (18) mit einer Hartvergußmasse (23), wobei die Hartvergußmasse (23) einen Raum im Bereich der Verrippung (11), einen Zwischenraum (24) zwischen Rahmen (10) und Gehäuse (18) und einen Raum oberhalb des Rahmens (10) vollständig ausfüllt.

11. Verfahren nach Anspruch 10, dadurch gekennzeichnet, daß der Rahmen (10) in einem zweiten Lötschritt bei gegenüber dem ersten Lötschritt niedrigerer Temperatur mit dem Substrat (1) verbunden wird.

12. Verfahren nach Anspruch 10, dadurch gekennzeichnet, daß der Rahmen (10) mit dem Substrat (1) nach einem Direct-Bonding-Verfahren verbunden wird.

13. Verfahren zur Herstellung des Leistungshalbleitermoduls nach Anspruch 1, gekennzeichnet durch nachstehende Verfahrensschritte:

a) Herstellen des Substrats (101) durch Aufbringen der Metallisierung (3) auf die Ober- und Unterseite der Keramikplatte (2) und Strukturierung der oberen Metallisierung (3) zu Leiterbahnen (4), wobei der Randbereich der Oberseite frei von einer Metallisierung bleibt,

b) Bestücken und Verlöten des Substrats (101) mit Bestückungselementen (6,8,9),

c) Bereitstellen des Rahmens (110) aus Keramik, wobei der Rahmen (110) in seinem oberen Bereich eine Verrippung (11) und an seinem Fuß einen Absatz (12) aufweist,

d) Verbinden des Rahmens (110) mit dem Substrat (101) zur Herstellung eines Zwischenprodukts (117) durch Verkleben der Unterseite des Absatzes (12) mit der Oberseite des Substrats (101) und Vergießen eines unteren Bereiches im Zwischenprodukt (117) bis einige Millimeter unterhalb der Verrippung (11) mit einer weichen Vergußmasse (15),

e) Einsetzen des Zwischenprodukts (117) in das Kunststoffgehäuse (18), das an seiner Oberseite Öffnungen zur Durchführung der Anschlußelemente (6) für äußere Anschlüsse (7) sowie zum Einfüllen einer Hartvergußmasse (23) aufweist, wobei das Kunststoffgehäuse (18) an seinem unteren Rand eine Ausnehmung (26) aufweist, im Bereich der Ausnehmung (26) und des Absatzes (12) am Rahmen (110) mit einer Dichtungsmasse (19) abgedichtet wird und

f) Vergießen des verbleibenden oberen Bereiches innerhalb des Gehäuses (18) mit einer Hartvergußmasse (23), wobei die Hartvergußmasse (23) einen Raum im Bereich der Verrippung (11) einen Zwischenraum (24) zwischen Rahmen (110) und Gehäuse (18) und einen Raum oberhalb des Rahmens (110) vollständig ausfüllt.

14. Verfahren nach Anspruch 13, dadurch gekennzeichnet, daß zum Verkleben des Substrats (101) mit dem Rahmen (110) ein Epoxidharz verwendet wird.

15. Verfahren zur Herstellung eines Leistungshalbleitermoduls nach dem Anspruch 1, gekennzeichnet durch nachstehende Verfahrensschritte:

a) Herstellen des Substrats (201) durch Aufbringen der Metallisierung (3) auf die Ober- und Unterseite der Keramikplatte (2) und Strukturierung der oberen Metallisierung (3) zu Leiterbahnen (4) und einen Metallrand (5),

b) Bereitstellen des Rahmens (210) aus Keramik, wobei der Rahmen (210) in seinem oberen Bereich keine Verrippung aufweist, jedoch in seinem unteren Bereich einen Zwischenboden (210) mit Aussparungen (202) zur Justierung von Bestückungselementen (6,8,9) sowie mit einem Absatz (12) zur Verbindung des Rahmens (210) mit dem Substrat (201),

c) Verbinden des Rahmens (210) mit dem Substrat (201) nach einem Direct-Bonding-Verfahren zur Herstellung eines Zwischenprodukts (217), wobei gleichzeitig die Metallisierung (3) auf der unteren Seite der Keramik (2) aufgebracht wird,

d) Bestücken des Zwischenprodukts (217) mit Bestükkungselementen (6,8,9) und Verlöten dieser Bestükkungselemente (6,8,9) mit dem Substrat (201),

e) Vergießen eines unteren Bereiches im Zwischenprodukt (217) mit einer weichen Vergußmasse (15),

f) Einsetzen eines Keramikeinsatzes (211) in den oberen Bereich des Rahmens (210) und Verbinden des Zwischenprodukts (217) mit dem Gehäuse (18) mit Hilfe einer Dichtungsmasse (19) und

g) Ausgießen des verbleibenden Innenraums im Kunststoffgehäuse (18) mit einer Hartvergußmasse (23).


16. Verfahren zur Herstellung eines Leistungshalbleitermoduls nach dem Anspruch 1, gekennzeichnet durch nachstehende Verfahrensschritte:

a) Herstellen des Substrats (1) durch Aufbringen der Metallisierung (3) auf die Oberseite der Keramikplatte (2) und Strukturierung dieser oberen Metallisierung (3) zu Leiterbahnen (4) und einen Metallrand (5),

b) Bereitstellen des Rahmens (310) aus Metall, der an seinem unteren Rand eine nach außen gebogenen Fuß (312) aufweist,

c) Verbinden des Rahmens (310) mit dem Substrat (1) nach einem Direct-Bonding-Verfahren, wobei gleichzeitig die untere Seite der Keramikplatte (2) metallisiert wird,

d) Einsetzen von Bestückungselementen (6,8,9) und Verlöten auf den Leiterbahnen (4) des Substrats (1),

e) Vergießen in einem unteren Bereich des Rahmens (310) mit einer weichen Vergußmasse (15)

f) Einsetzen des Substrats (1) mit dem Rahmen (310) in das Gehäuse (18) und Abdichtung mit einer Dichtungsmasse (15) und

g) Vergießen des verbleibenden Innenraums des Gehäuses (18) mit einer Hartvergußmasse (23).

Fig. 2

Fig. 1

Fig. 3

Fig. 5

Fig. 4

Fig. 6

Fig. 7

_17_

Fig. 8

_14_

Fig. 9

Fig. 10

Fig. 11

Fig. 13

Fig. 12

Fig. 14

Fig. 15

0237739

Fig. 16

214

Fig. 17

314

Fig. 18